(19) Europäisches Patentamt / European Patent Office / Office européen des brevets

(11) **EP 4 467 700 B1**

(12) **EUROPÄISCHE PATENTSCHRIFT**

(45) Veröffentlichungstag und Bekanntmachung des Hinweises auf die Patenterteilung:
**14.01.2026 Patentblatt 2026/03**

(21) Anmeldenummer: **23175153.8**

(22) Anmeldetag: **24.05.2023**

(51) Internationale Patentklassifikation (IPC):
**D04B 27/02** (2006.01)    **D04B 27/04** (2006.01)
**D04B 27/06** (2006.01)    **B65H 57/24** (2006.01)
**C23C 16/26** (2006.01)

(52) Gemeinsame Patentklassifikation (CPC):
**D04B 27/02; B65H 57/24; C23C 16/26;**
**D04B 27/04; D04B 27/06;** B65H 2701/31;
C23C 14/0605

(54) **TEXTILWERKZEUG, TEXTILWERKZEUGVERBUND UND TEXTILMASCHINE ZUR HERSTELLUNG EINES TEXTILEN FLÄCHENGEBILDES**

TEXTILE TOOL, TEXTILE TOOL COMPOSITE AND TEXTILE MACHINE FOR PRODUCING A TEXTILE FABRIC

OUTIL TEXTILE, ENSEMBLE D'OUTIL TEXTILE ET MACHINE TEXTILE POUR LA FABRICATION D'UNE STRUCTURE TEXTILE PLANE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(43) Veröffentlichungstag der Anmeldung:
**27.11.2024 Patentblatt 2024/48**

(73) Patentinhaber: **KARL MAYER STOLL R&D GmbH**
**63179 Obertshausen (DE)**

(72) Erfinder:
- **HARMELING, Frank**
  **73110 Hattenhoffen (DE)**
- **SCHULER, Günter**
  **64850 Schaafheim (DE)**
- **STOCKENHOFEN, Frank**
  **63165 Mühlheim am Main (DE)**
- **SCHADT, Heiko**
  **63853 Mömlingen (DE)**
- **GRASHOFF, Tobias**
  **63303 Dreieich (DE)**
- **SAAL, Torsten**
  **64823 Groß-Umstadt (DE)**
- **BACK, Torsten**
  **63691 Ranstadt (DE)**
- **KRESTEL, Wilhelm**
  **63589 Linsengericht (DE)**
- **LÖW, Rainer**
  **63500 Selingenstadt (DE)**
- **OTT, Christian**
  **63165 Mühlheim am Main (DE)**
- **SCHULZE, Klaus**
  **37520 Osterode (DE)**
- **LILOV, Mihail**
  **63517 Rodenbach (DE)**
- **ARNOLD, Matthias**
  **63755 Alzenau (DE)**

(74) Vertreter: **MERH-IP Matias Erny Reichl Hoffmann**
**Patentanwälte PartG mbB**
**Paul-Heyse-Straße 29**
**80336 München (DE)**

(56) Entgegenhaltungen:
EP-A1- 2 628 822    CN-A- 115 044 869
DE-A1- 102010 002 687    DE-A1- 102010 052 971
DE-A1- 102018 119 910    DE-A1- 19 635 736
JP-A- 2014 221 962

- LECHTHALER LUKAS ET AL: "Reibungs- und Verschleissreduktion im Strickprozess", JOT JOURNAL F�R OBERFL�CHENTECHNIK, 30 November 2020 (2020-11-30), pages 38 - 41, XP093099352, Retrieved from the Internet <URL:https://link.springer.com/content/pdf/10.1007/s35144-020-0973-9.pdf> [retrieved on 20231108]

## Beschreibung

## Technisches Gebiet

Die vorliegende Erfindung betrifft ein Textilwerkzeug, einen Textilwerkzeugverbund sowie eine Textilmaschine zur Fertigung von textilen Flächengebilden.

## Hintergrund der Erfindung

Im Zuge der automatisierten Fertigung von textilen Flächengebilden kommen Textilmaschinen zum Einsatz, die eine Vielzahl von einzelnen Textilfäden miteinander auf teilweise unterschiedliche Weisen verarbeiten, um so ein textiles Flächengebilde herzustellen.

Hierzu sind im technischen Gebiet der Textilverarbeitung Web-, Strick- oder Wirkmaschinen bekannt, deren Funktionsweisen zur Verarbeitung der Textilfäden sich grundlegend unterscheiden. So erfolgt beispielsweise die Verarbeitung an einer Webmaschine durch rechtwinkliges Verweben der Textilfäden, die abwechselnd über- und untereinander verlaufen, wohingegen die Verarbeitung an der Wirkmaschine durch Maschenbildung erfolgt

Unbenommen dieser Unterschiede werden bei sämtlichen fadenverarbeitenden Textilmaschinen die einzelnen Textilfäden einem Arbeitsbereich der Textilmaschine zugeführt, in dem die Verarbeitung durch Relativbewegungen mehrerer mit den Textilfäden in Kontakt stehenden Textilwerkzeuge erfolgt.

Im Wege der Verarbeitung werden die Textilwerkzeuge dabei durch abrasive Eigenschaften der Textilfäden, Reibung, Prozesskräfte, chemische Substanzen usw. in Mitleidenschaft gezogen, was unter anderem zu Verschleiß oder zu Veränderungen der Reibwerte im Kontakt mit den Textilfäden führt Dies beeinflusst wiederum die Genauigkeit der Fadenführung am Textilwerkzeug und führt ebenso zu zunehmender Beschädigung der Textilfäden, was sich negativ auf die Qualität des textilen Flächengebildes auswirkt Ab einem gewissen Schädigungsgrad sind die Textilwerkzeuge letztlich nicht mehr verwendbar und müssen ausgetauscht werden, was aufgrund der Vielzahl von Textilwerkzeugen in einer Textilmaschine zu langen Stillstandzeiten der selbigen führt

Um vor diesem Hintergrund die Widerstandsfähigkeit der Textilwerkzeuge und damit auch deren Einsatzdauer zu erhöhen, weisen diese zumindest im fadenführenden Bereich eine Beschichtung auf, die im Vergleich zu einem darunter liegenden Werkzeugkern den obenstehenden Belastungen besser standhalten kann. Dabei sind unter anderem auch die unterschiedlichen Arten von Textilfäden im Auge zu behalten, die von sehr robusten Textilfäden, die die Textilwerkzeuge überdurchschnittlich verschleißen, bis hin zu hoch sensitiven Textilfäden reichen, die bereits durch geringste Unregelmäßigkeiten im Kontakt mit dem Textilwerkzeug beschädigt werden können.

Aus der DE 19 635 736 A1 ist so beispielswiese ein Verfahren zum Herstellen einer DLC-Beschichtung auf einem Verschleißteil einer Textilmaschine bekannt, um so deren Verschleißfestigkeit zu erhöhen. Ähnlich hierzu ist aus der JP 2014 221 962 A eine Stricknadel bekannt, die mit einer DLC-Beschichtung versehen ist, um deren Verschleißfestigkeit zu erhöhen.

Weiter ist aus der DE 10 2018 119 910 A1 eine Stricknadel bekannt, auf deren Oberfläche ta-C abgeschieden ist.

Weiterer Stand der Technik aus dem Bereich der Beschichtungstechnik ist zudem aus der DE 10 2010 002 687 A1 und aus der DE 10 2010 052 971 A1 bekannt.

Im Stand der Technik hat sich hier in den vergangenen Jahren eine Hartchrom-Beschichtung (Chrom VI, Chromtrioxid) zur Erhöhung der Widerstandsfähigkeit (siehe beispielsweise EP 3 483 319 A1) etabliert, deren Eigenschaften einen guten Kompromiss darstellen für die Verarbeitung sowohl der besagten stark verschleißenden und als auch der hoch sensitiven Textilfäden mit demselben Textilwerkzeug, das heißt ohne eine Textilfaden spezifische Beschichtung des Textilwerkzeugs. In den besagten, Extremfällen weist besagte Hartchrom-Beschichtung jedoch vergleichsweise schlechte Arbeitsergebnisse auf. Zudem ist die Herstellung von Hartchrom im hohen Maße gesundheits- und umweltschädlich.

## Zusammenfassung der Erfindung

Eine Aufgabe der vorliegenden Erfindung ist es daher, eine gegenüber dem Stand der Technik verbesserte Möglichkeit zur maschinellen Herstellung textiler Flächengebilde bereitzustellen, insbesondere im Hinblick auf eine wirtschaftliche Herstellung von Flächengebilde mit hoher Produktqualität

Zur Lösung dieser Aufgabe wird ein beschichtetes Textilwerkzeug nach Anspruch 1, ein Textilwerkzeugverbund nach Anspruch 14 sowie eine Textilmaschine zur Herstellung eines textilen Flächengebildes unter Einsatz des besagten Textilwerkzeugs nach Anspruch 15 bereitgestellt.

Die jeweiligen abhängigen Ansprüche beziehen sich dabei auf bevorzugte Ausführungsformen, die jeweils für sich genommen oder in Kombination bereitgestellt werden können.

Gemäß eines ersten Aspekts der Erfindung wird ein Textilwerkzeug zum Einsatz in einer Textilmaschine bereitgestellt, das einen Arbeitsabschnitt zum Einwirken auf einen Textilfaden im Zuge einer Herstellung eines textilen Flächengebildes aufweist, wobei das Textilwerkzeug einen Werkzeugkern aus einem Kernmaterial umfasst, auf den zumindest im Arbeitsabschnitt eine Beschichtung zum Verschleißschutz aufgebracht ist. Die Beschichtung umfasst dabei zumindest ein Haftvermittlungsmaterial und tetraedrischen amorphen Kohlenstoff, kurz ta-C, als Verschleißschutzmaterial.

Die Bezeichnungen "zum Verschleißschutz", "verschleißfest" oder dergleichen sind in Bezug auf die Beschichtung im Kontext der Erfindung so zu verstehen, dass die Beschichtung eine höhere Widerstandsfähigkeit gegen Materialabtrag und/oder eine höhere Festigkeit und/oder eine höhere Härte aufweist als das darunter liegende Kernmaterial, aus dem der Werkzeugkern hergestellt ist, üblicherweise Stahl oder eine andere Metalllegierung.

Bei tetraedrischem amorphen Kohlenstoff (ta-C) handelt es sich um wasserstoffarmen, amorphen Kohlenstoff mit einem überwiegenden $sp^3$-Hybridisierungsanteil, also mindestens 50 %, vorzugweise über 70 % aller vorhanden Bindungen. ta-C zeichnet sich üblicherweise durch hohen elektrischen Widerstand, extreme Härte und optische Transparenz aus. Die Synthese kann beispielsweise mittels Verfahren zur physikalischen Gasphasenabscheidung erfolgen, kurz PVD-Verfahren.

Unter Beschichtung ist dabei jedweder auf den bestehenden Werkzeugkern aufgebrachter Verbund zu verstehen, der insbesondere aus vom Kernmaterial abweichenden Materialien zusammengesetzt ist Es kann sich hierbei um einzelne aber auch um mehrere Schichten handeln, die in beliebiger Reihenfolge aufgebracht sein können.

Unter dem textilen Flächengebilde ist jedwedes Textilerzeugnis unabhängig von einem jeweiligen Herstellungsverfahren zu verstehen. Beispiele hierfür sind Gewebe, Maschenwaren, Filze, Teppiche, Tufting-Teppiche, Vliesstoffe, Bobinet, Netze, Geflechte, Multitextilien oder Nähwirkwaren.

Zur Herstellung des textilen Flächengebildes erfolgt die Verarbeitung einer Vielzahl von Textilfäden durch die in einem Arbeitsbereich der Textilmaschine angeordneten Textilwerkzeuge (im Falle einer Wirkmaschine zum Beispiel durch Wirkwerkzeuge, wie Loch- und Schiebernadeln), die sich relativ zueinander im Arbeitsbereich bewegen, insbesondere mittels entsprechender Antriebe und Getriebe, um die Vielzahl von Textilfäden miteinander zu vermaschen, zu verknüpfen, zu verweben, zu verstricken oder dergleichen.

Die Erfinder haben nun herausgefunden, dass durch eine Beschichtung mit ta-C eine besonders harte Oberfläche erzielt werden kann, die lediglich eine geringe Anfälligkeit in Bezug auf Materialabtrag aufweist Die auf die Verschleißfestigkeit bezogenen Eigenschaften sind dabei besser als bei der konventionellen Hartchrom-Beschichtung und zudem kann ein besserer, also ein niedrigerer, Reibungskoeffizient im Kontakt mit einem Textilfaden erreicht werden.

Durch Einsatz des Verschleißschutzmaterials ta-C als Teil der den Werkzeugkern zumindest im Arbeitsabschnitt überdeckenden Beschichtung zeichnet sich das Textilwerkzeug zumindest dort durch eine hohe Widerstandsfähigkeit gegen Materialabtrag aus, sodass in Folge des Reibkontakts mit dem Textilfaden über die Zeit nur äußerst wenig Material im Arbeitsabschnitt abgetragen wird.

Dies gewährleistet wiederum eine lange Lebensdauer der Textilwerkzeuge und senkt damit Stillstandzeiten als auch Wartungskosten der Textilmaschine, da die Textilwerkzeuge nun seltener ausgetauscht werden müssen.

Ferner wird durch den niedrigen Reibungskoeffizienten ein Gleiten des Textilfadens über den Arbeitsabschnitt im Zuge der Verarbeitung erleichtert, sodass dieser gleichmäßiger und damit kontrollierter dem Arbeitsabschnitt der Textilmaschine zugeführt werden kann. Ebenso kann durch die geringere Reibung im Kontakt auch das Risiko einer Beschädigung des Textilfadens reduziert werden, wodurch wiederum die Produktqualität des letztlich herzustellenden textilen Flächengebildes erhöht wird.

Das Haftvermittlungsmaterial sorgt dabei für eine besseren Verbund zwischen der Beschichtung und dem Werkzeugkern, um so ein Ablösen bzw. ein Abplatzen der Beschichtung zu verhindern. So reduziert der Einsatz des Haftvermittlungsmaterials unter anderem die inneren Spannungen im Übergang zwischen Werkzeugkern und Beschichtung.

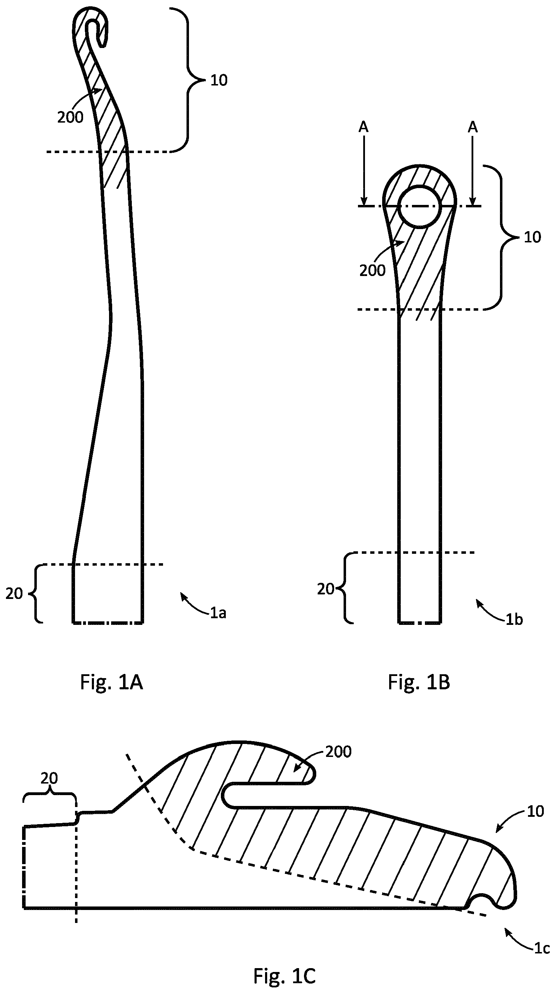

Vorzugsweise handelt es sich bei dem Textilwerkzeug um ein Wirkwerkzeug, also um ein Textilwerkzeug zum Einsatz in einer Wirkmaschine. Insbesondere und nicht beschränkend kann es sich hierbei um eine Lochnadel, eine Schiebernadel oder Wirkplatine handeln (siehe auch Fig. 1A bis 1C), aber auch um eine Schieberplatine, einen Stechkamm eine Abschlagkammplatine oder eine Fadenkammlamelle.

Obgleich die Beschichtung zumindest im Arbeitsabschnitt aufgebracht sein soll, kann diese auch in Bereichen aufgebracht sein, die per se keinen Kontakt mit dem Textilfaden aufweisen. Üblicherweise weisen die Textilwerkzeuge einen Halteabschnitt zur Einspannung in der Textilmaschine auf, wobei die Beschichtung vorzugsweise lediglich im Halteabschnitt ausgespart ist, also alle übrigen Bereiche des Werkzeugkerns überdeckt.

In einer bevorzugten Ausführungsform ist das Haftvermittlungsmaterial aus der Gruppe Cr, CrN, Ti, TiAlN ausgewählt. Andere Haftvermittlungsmaterialien sind ebenfalls möglich.

Besagte Materialien sind vergleichsweise günstig und haben eine besonders gute Wirkung im Hinblick auf den Abbau innerer Spannungen im Übergang zwischen Werkzeugkern und Beschichtung.

In einer bevorzugten Ausführungsform ist das Haftvermittlungsmaterial Wolfram dotiertes DLC, kurz W-DLC. DLC ist dabei die gängige Bezeichnung für diamantähnlichen Kohlenstoff (engl.: diamond-like carbon).

W-DLC selbst weist eine im Vergleich zum Kernmaterial hohe Festigkeit auf und hat zudem glättende Eigenschaften zur Senkung von Oberflächenrauheiten.

In einer bevorzugten Ausführungsform ist der Werkzeugkern des Textilwerkzeugs derart ausgestaltet, dass Krümmungsradien einer Oberfläche im Arbeitsabschnitt des Textilwerkzeugs größer gleich 40 μm sind, weiter bevorzugt größer gleich 50 μm und besonders bevorzugt größer gleich 70 μm.

In anderen Worten liegt ein minimal zulässiger Krümmungsradius im Arbeitsabschnitt bei 40 μm bzw. bei 50 μm oder 70 μm.

Aufgrund der vergleichsweise hohen Druckeigenspannungen im ta-C kann durch Einhaltung dieser Krümmungsgrenze das Risiko eines Abplatzens der Beschichtung zusätzlich reduziert werden.

In einer bevorzugten Ausführungsform umfasst die Beschichtung zumindest eine Haftvermittlungsschicht aus dem Haftvermittlungsmaterial und einer Verschleißschutzschicht aus dem ta-C, wobei die Haftvermittlungsschicht zwischen dem Werkzeugkern und der Verschleißschutzschicht angeordnet ist.

Eine derartige Anordnung ist besonders einfach über ein mehrstufiges Verfahren, insbesondere ein PVD-Verfahren, umzusetzen und bietet eine besonders verschleißfeste Oberfläche und reduziert das Risiko von Abplatzungen durch die zwischengelagerte Haftvermittlungsschicht.

In der Ausführung mit Haftvermittlungsschicht und Verschleißschutzschicht bietet sich vor allem der Einsatz von W-DLC als Haftvermittlungsmaterial an, da dieser die besagte Festigkeit sowie glättende Eigenschaften in Bezug auf die darüber liegende Verschleißschutzschicht aufweist, mit der Mikrorauheiten an der Oberfläche der Verschleißschutzschicht geringer ausfallen als bei anderen, konventionellen Haftvermittlungsmaterialien.

Eine rauere Oberfläche erhöht nicht nur den Reibungskoeffizienten, sondern ist auch Quelle für Beschädigung der Textilfäden, sodass eine vergleichsweise glatte Oberfläche bevorzugt wird.

Bedingt durch Beschichtungsverfahren mit sukzessivem Aufbau der jeweiligen Schicht steigen Oberflächenrauheiten mit zunehmender Schichtdicke an, sodass ein ggfs. einzuhaltender, vordefinierter Oberflächenrauheitswerts die Schichtdicke nach oben beschränkt.

Durch Einsatz von W-DLC kann diese Grenze beim Auftragen der Verschleißschutzschicht aus ta-C nach oben verschoben werden, sodass auch dickere Verschleißschutzschichten aufgebracht werden können.

So haben die Erfinder im direkten Vergleich herausgefunden, dass eine ta-C-Schicht, die auf das üblicherweise metallische Kernmaterial aufgebracht ist, im Vergleich zu einer ta-C-Schicht gleicher Dicke, die auf W-DLC aufgebracht ist, eine höhere Oberflächenrauheit aufweist als die auf W-DLC aufgebrachte ta-C-Schicht

Somit bietet der Einsatz von W-DLC als Haftvermittlungsmaterial die Möglichkeit, Verschleißschutzschichten mit besonders glatter Oberfläche umsetzen zu können, was wiederum die Möglichkeit dickerer Verschleißschutzschichten bietet, ohne dabei ein Überschreiten des besagten vordefinierten Oberflächenrauheitswerts in Kauf nehmen zu müssen.

In einer bevorzugten Ausführungsform liegt eine Dicke der Verschleißschutzschicht zwischen 0,1 und 3 μm, weiter bevorzugt zwischen 0,3 und 2 μm und besonders bevorzugt zwischen 0,3 und 1 μm.

In einer bevorzugten Ausführungsform liegt eine Dicke der Haftvermittlungsschicht zwischen 0,01 und 2 μm, weiter bevorzugt zwischen 0,2 und 0,8 μm und besonders bevorzugt zwischen 0,4 und 0,5 μm.

Die Dicke einer Schicht kann dabei vorzugsweise die Dicke in Bezug auf jeden einzelnen ausgezeichneten Oberflächenpunkt der Schicht sein, aber auch eine über eine Linie oder eine über die Fläche der Schicht gebildete Kenngröße, zum Beispiel in Form eines Mittelwerts, also ein Mittel über alle möglichen Linien- bzw. Oberflächenpunkte besagter Linie bzw. Fläche.

Vorzugsweise variiert die Dicke der Haftvermittlungsschicht und/oder der Verschleißschutzschicht im Arbeitsabschnitt, sodass an den jeweils besonders beanspruchten Stellen beispielsweise ein stärkerer Verschleißschutz umgesetzt werden kann als an weniger beanspruchten Stellen.

In einer bevorzugten Ausführungsform, bei der das Haftvermittlungsmaterial W-DLC ist, weist die Haftvermittlungsschicht eine Dicke zwischen 0,1 und 10 μm, vorzugsweise zwischen 1 und 5 μm, auf und die Verschleißschutzschicht weist eine Dicke zwischen 0,1 und 10 μm, vorzugsweise zwischen 1 und 5 μm, auf.

In einer bevorzugten Ausführungsform ist die Beschichtung als Mehrlagenschicht ausgeführt, die zwei oder mehr Schichten aus dem Haftvermittlungsmaterial und zwei oder mehr Schichten aus dem ta-C umfasst, die in einer Dickenrichtung der Mehrlagenschicht jeweils abwechselnd angeordnet sind.

Durch die abwechselnde Anordnung jeweils einer Haftvermittlungsschicht und einer Verschleißschutzschicht im Sinne der Erfindung, können die inneren Spannungen im Gesamtverbund aus Werkzeugkern und Beschichtung weiter reduziert werden, um so das Risiko eines Abplatzens weiter zu reduzieren.

Vorzugsweise liegt eine Dicke der Mehrlagenschicht zwischen 0,5 und 20 μm, weiter bevorzugt zwischen 1 und 10 μm. Vorzugsweise weisen die einzelnen Schichten aus dem Haftvermittlungsmaterial im Wesentlichen die gleiche Dicke auf und weiter vorzugsweise gilt dies auch für die Schichten aus dem ta-C.

Besonders bevorzugt weist die äußerste Schicht aus ta-C am Textilfaden-seitigen Ende der Beschichtung eine größere Dicke auf, als die vorhergehenden Schichten aus ta-C, um den Verschleißschutz weiter zu verbessern,

Vorzugsweise variiert die Dicke der Mehrlagenschicht im Arbeitsabschnitt, sodass an den jeweils besonders beanspruchten Stellen beispielsweise ein stärkerer Verschleißschutz umgesetzt werden kann als an weniger beanspruchten Stellen.

In einer bevorzugten Ausführungsform umfasst die Beschichtung eine Hybridschicht aus einer Materialmischung zumindest aus dem Haftvermittlungsmaterial und dem ta-C (oder ist als solche ausgeführt).

Anstelle das Haftvermittlungsmaterial und das ta-C in voneinander getrennten Schichten auf dem Werkzeugkern bzw. aufeinander anzuordnen, wird eine einzige Schicht aus einer Mischung der besagten Materialien aufgebracht.

Die Hybridschicht soll dabei so verstanden werden, dass jedwedes Volumenelement der Hybridschicht sowohl ta-C als auch das Haftvermittlungsmaterial enthält. Die schließt allerdings nicht aus, dass eine Konzentration des ta-C bei Annäherung an ein Beschichtungsende, insbesondere in Dickenrichtung, den Maximalwert von 100% oder den Minimalwert von 0% an ta-C erreichen

In einer bevorzugten Ausführungsform ist die Hybridschicht eine Gradientenschicht, bei der eine Konzentration des ta-C zumindest in Dickenrichtung der Gradientenschicht variiert.

Die Bezeichnung Konzentration soll hierbei gleichbedeutend mit einem Anteil oder einem Massenanteil eines Bestandteils der Materialmischung verstanden werden und kann beispielsweise in ppm oder Massen-% angegeben werden.

Unter Dickenrichtung kann dabei die an einem ausgezeichneten Punkt des Textilwerkzeugs orthogonal zu einer Oberfläche der Gradientenschicht oder zur Oberfläche des darunter liegenden Werkzeugkerns verlaufende Normalenrichtung verstanden werden. Je nach Kontur des Textilwerkzeugs können Dickenrichtungen unterschiedlicher Punkte parallel oder aber auch winklig zueinander verlaufen.

Die in Dickenrichtung variierende Konzentration soll dabei so verstanden werden, dass es zumindest einen Punkt auf der Gradientenschicht gibt, bezüglich dessen die Konzentration entlang der zugehörigen Dickenrichtung, die dabei der punktspezifischen Dickenrichtung durch den besagten Punkt entspricht, über die Dicke der Gradientenschicht hinweg variiert.

Gemäß dessen ist die Konzentration des ta-C nicht über die gesamte Dicke der Gradientenschicht hinweg konstant, sondern veränderlich und kann beispielsweise über eine Konzentrationsfunktion in Abhängigkeit von zum Beispiel der absoluten oder prozentualen Schichtdicke in der Dickenrichtung der Gradientenschicht angegeben werden.

Durch den Einsatz einer Gradientenschicht kann im Vergleich zur Ausführung mit getrennten Schichten, also mit den zwei Schnittstellen Werkzeugkern/Haftvermittlungsschicht und Haftvermittlungsschicht/Verschleißschutzschicht, ein besonders stetiger Verlauf innerer Spannungen ohne Spannungsspitzen umgesetzt werden, wodurch sich das Risiko von Abplatzungen der Beschichtung zusätzlich reduzieren lässt.

Vorzugsweise liegt eine Dicke der Gradientenschicht zwischen 0,1 und 20 µm, weiter bevorzugt zwischen 0,5 und 10 µm.

Vorzugsweise variiert die Dicke der Gradientenschicht im Arbeitsabschnitt, sodass an den jeweils besonders beanspruchten Stellen beispielsweise ein stärkerer Verschleißschutz umgesetzt werden kann als an weniger beanspruchten Stellen.

Vorzugsweise liegt eine Konzentration an ta-C am Werkzeugkern-seitigen Ende der Gradientenschicht zwischen 0% und 50%, weiter bevorzugt zwischen 0% und 25%, besonders bevorzugt zwischen 0% und 10 %. Insbesondere kann die Konzentration 5%, 1%, 0,1%, 0,01% oder 0,001% betragen.

Vorzugsweise liegt eine Konzentration des Haftvermittlungsmaterials am Werkzeugkern-seitigen Ende der Gradientenschicht zwischen 50% und 100%, weiter bevorzugt zwischen 75% und 100%, besonders bevorzugt zwischen 90% und 100%. Insbesondere kann die Konzentration 95%, 99%, 99,9%, 99,99% oder 99,999% betragen.

Vorzugsweise liegt eine Konzentration an ta-C am Textilfaden-seitigen Ende der Gradientenschicht zwischen 50% und 100%, weiter bevorzugt zwischen 75% und 100%, besonders bevorzugt zwischen 90% und 100%. Insbesondere kann die Konzentration 95%, 99%, 99,9%, 99,99% oder 99,999% betragen.

Vorzugsweise liegt eine Konzentration des Haftvermittlungsmaterials am Textilfaden-seitigen Ende der Gradientenschicht zwischen 0% und 50%, weiter bevorzugt zwischen 0% und 25%, besonders bevorzugt zwischen 0% und 10%. Insbesondere kann die Konzentration 5%, 1%, 0,1%, 0,01% oder 0,001% betragen.

Die vorstehend angegebenen Konzentrationen können als Massen-% verstanden werden.

Vorzugsweise weist die Gradientenschicht einen Oberflächenabschnitt auf, bezüglich dessen die Konzentration für jede Dickenrichtung der im Oberflächenabschnitt liegenden Punkte variiert. Alternativ kann die variierende Konzentration aber auch als Mittelwert über alle Punkte des Oberflächenabschnitts verstanden werden.

Vorzugsweise beträgt besagter Oberflächenabschnitt 10 bis 100 % einer Oberfläche der Gradientenschicht

In einer bevorzugten Ausführungsform ist die Konzentration an ta-C an einem Textilfaden-seitigen Ende der Gradientenschicht maximal.

Dadurch weist die Gradientenschicht im Kontakt mit dem Textilfaden ebenso ihre maximale Widerstandsfähigkeit auf.

In einer bevorzugten Ausführungsform ist die Konzentration des Haftvermittlungsmaterials an einem Werkzeugkern-seitigen Ende der Gradientenschicht maximal.

Dadurch werden die in der einen verbleibenden Schnittstelle auftretenden inneren Spannungen minimal.

In einer bevorzugten Ausführungsform steigt die Konzentration an ta-C in der Gradientenschicht in Dickenrichtung ausgehend von einem Werkzeugkernseitigen Ende bis zu einem Textilfaden-seitigen Ende der Gradientenschicht an, insbesondere ist die Konzentration an ta-C in Dickenrichtung monoton steigend.

Alle vorstehend beschriebenen Ausführungsformen stellen ein verschleißfestes Textilwerkzeug bereit, das eine lange Lebensdauer aufweist und zudem die Beschädigung an Textilfäden vergleichsweise geringhält, um so textile Flächengebilde hoher Produktqualität herstellen zu können.

Gemäß eines zweiten Aspekts der Erfindung wird ein Textilwerkzeugverbund bereitgestellt, der eine Vielzahl von Textilwerkzeugen und ein Halteelement umfasst. Die Textilwerkzeuge sind gemäß des ersten Aspekts oder einer von dessen bevorzugten Ausführungsformen ausgeführt und sind nebeneinander am Halteelement befestigt.

Auf diese Weise werden die Textilwerkzeuge zum Einsatz an der Textilmaschine in Verbundform bereitgestellt, sodass durch lediglich eine Montagehandlung, nämlich der Montage des Halteelements in der Textilmaschine, gleich mehrere Textilwerkzeuge in der Textilmaschine montiert werden können, was wiederum die Stillstandzeiten senkt.

Das Halteelement kann dabei als eine Art Fassung für die Textilwerkzeuge verstanden werden.

Die Textilwerkzeuge sind dabei insbesondere parallel zueinander entlang einer ersten Richtung mit einem dazwischen vorgesehenen Abstand im oder am Halteelement befestigt, wobei die Befestigung form- und/oder kraftschlüssig zwischen dem Haltelement und jeweiligen Halteabschnitten der Textilwerkzeuge erfolgen kann.

Eine Befestigung erfolgt vorzugsweise über ein Einbringen der Textilwerkzeuge in flüssiges Material des Halteelements und anschließendes Erstarren des selbigen. Wahlweise kann auch eine Befestigung über eine Klebung, beispielsweise mit einem Epoxidharz, erfolgen.

Ein Material des Halteelements ist vorzugsweise ein Kunststoff, insbesondere ein Thermoplast, oder eine Leichtmetalllegierung. Ebenso kann auch Blei oder Zink eingesetzt werden, da diese eine vergleichsweise niedrige Schmelztemperatur aufweist.

Das Haltelement ist dabei derart ausgestaltet, um in eine zugehörige Aufnahme der Textilwerkzeuge, zum Beispiel in Aufnahmeabschnitte eines Barren einer Wirkmaschine, aufgenommen zu werden.

Eine Anordnungsdichte der Textilwerkzeuge in der ersten Richtung beträgt je nach Ausprägung des zu fertigenden Flächengebildes zwischen 5 und 100 Textilwerkzeugen, insbesondere Lochnadeln, pro Zoll (entspricht 2,54 cm). Vorzugsweise liegt die Anordnungsdichte zwischen 10 und 70 Textilwerkzeugen, insbesondere Lochnadeln, pro Zoll und besonders bevorzugt zwischen 18 und 50 Textilwerkzeugen, insbesondere Lochnadeln, pro Zoll.

Eine Länge des Halteelements in der ersten Richtung kann dabei zwischen 0,5 und 4 Zoll betragen, vorzugsweise 0,5, 1, 2, 3 oder 4 Zoll.

Vorzugsweise handelt es sich um einen Lochnadelverbund zum Einsatz in einer Wirkmaschine, bei der eine Vielzahl von Lochnadelverbunden wiederum an einem Barren der Wirkmaschine befestigt werden kann, um diese mit den Lochnadeln auszustatten.

Gemäß eines dritten Aspekts der Erfindung wird eine Textilmaschine zur Herstellung von textilen Flächengebilden bereitgestellt, die eine Vielzahl von Textilwerkzeugen umfasst sowie einen Arbeitsbereich, in dem die Textilmaschine eine Vielzahl von Textilfäden mittels der Vielzahl von Textilwerkzeugen zu einem textilen Flächengebilde verarbeitet. Zumindest eines der Textilwerkzeuge (vorzugsweise mehrere und besonders bevorzugt alle) ist ein Textilwerkzeug gemäß des ersten Aspekts oder einer von dessen bevorzugten Ausführungsformen.

Auf diese Weise wird eine Textilmaschine bereitgestellt, die eine maschinelle, automatisierte Herstellung textiler Flächengebilde ermöglicht und dabei die vorstehenden beschriebenen Vorteile beim Einsatz des erfindungsgemäßen Textilwerkzeugs bietet.

Die erfindungsgemäße Textilmaschine zeichnet sich damit unter anderem durch besonders lange Betriebszeiten aus, da die Textilwerkzeuge selbst eine hohe Lebensdauer aufweisen, sowie durch eine durchweg hohe Fertigungsqualität aus, da Beschädigungen der Textilfäden im Zuge der Verarbeitung gering gehalten werden.

Vorzugsweise ist die Textilmaschine eine Wirkmaschine (oder Kettenwirkmaschine), bei der der Arbeitsbereich ein Wirkbereich ist, in dem das textile Flächengebilde als Maschenware hergestellt wird.

Vorzugsweise umfasst die Vielzahl von Textilwerkzeugen gemäß des ersten Aspekts der Erfindung eine oder mehrere Lochnadeln und/oder eine oder mehrere Schiebernadeln und/oder eine oder mehrere Wirkplatinen.

Weitere Aspekte und deren Vorteile als auch speziellere Ausführungsbeispiele der zuvor genannten Aspekte und Merkmale werden im Folgenden unter Zuhilfenahme der in den beigefügten Figuren gezeigten Zeichnungen beschrieben.

Fig. 1A bis 1C zeigen verschiedene Ausführungsbeispiele des erfindungsgemäßen Textilwerkzeugs in Form einer Schiebernadel, einer Lochnadel und einer Wirkplatine.

Fig. 2 zeigt ein erstes Ausführungsbeispiel einer Beschichtung des erfindungsgemäßen Textilwerkzeugs.

Fig. 3 zeigt ein zweites Ausführungsbeispiel einer Beschichtung des erfindungsgemäßen Textilwerkzeugs.

Fig. 4 zeigt ein drittes Ausführungsbeispiel einer Beschichtung des erfindungsgemäßen Textilwerkzeugs.

Fig. 5A bis 5C zeigen exemplarische Verläufe einer ta-C-Konzentration in der Gradientenschicht des dritten Ausführungsbeispiels.

Fig. 6 zeigt eine schematische Gegenüberstellung bei Einsatz von W-DLC als Haftvermittlungsmaterial.

**Ausführliche Figurenbeschreibung**

Fig. 1A bis 1C zeigen verschiedene Ausführungsbeispiele des erfindungsgemäßen Textilwerkzeugs in Form einer Schiebernadel 1a (Fig. 1A), einer Lochnadel 1b (Fig. 1B) und einer Wirkplatine 1c (Fig. 1C).

Alle exemplarisch gezeigten Textilwerkzeuge 1a, 1b, 1c weisen dabei einen Arbeitsabschnitt 10 zum Einwirken auf einen Textilfaden sowie einen Halteabschnitt 20 zum Einspannen in eine Textilmaschine auf.

Die Arbeitsabschnitte 10 sowie die Halteabschnitte 20 sind dabei durch die mit gestrichelten Linien abgesteckten Abschnitte angedeutet und lediglich exemplarisch gewählt. So kann insbesondere der Arbeitsabschnitt 10 der einzelnen Textilwerkzeuge 1a, 1b, 1c größer oder kleiner ausfallen als dargestellt.

Die Textilwerkzeuge 1a, 1b, 1c weisen dabei allesamt einen auf den jeweiligen Werkzeugkern aufgebrachte Beschichtung 200 auf, über die das Textilwerkzeug 1a, 1b, 1c vor Verschleiß geschützt werden soll. Die Beschichtung 200 ist jeweils durch die schraffierte Fläche angedeutet.

Die Beschichtung 200 ist dabei zumindest im Arbeitsabschnitt 10 des jeweiligen Textilwerkezugs 1a, 1b, 1c aufgebracht, kann aber auch über diesen hinausreichen, wie dies beispielsweise in den Fig. 1A und 1B angedeutet ist.

Erfindungsgemäß umfasst die Beschichtung 200 dabei zumindest ein Haftvermittlungsmaterial zur Verbesserung der Haftung der Beschichtung 200 am Werkzeugkern sowie ta-C als Verschleißschutzmaterial, um die Widerstandsfähigkeit des Textilwerkzeugs 1a, 1b, 1c zu erhöhen.

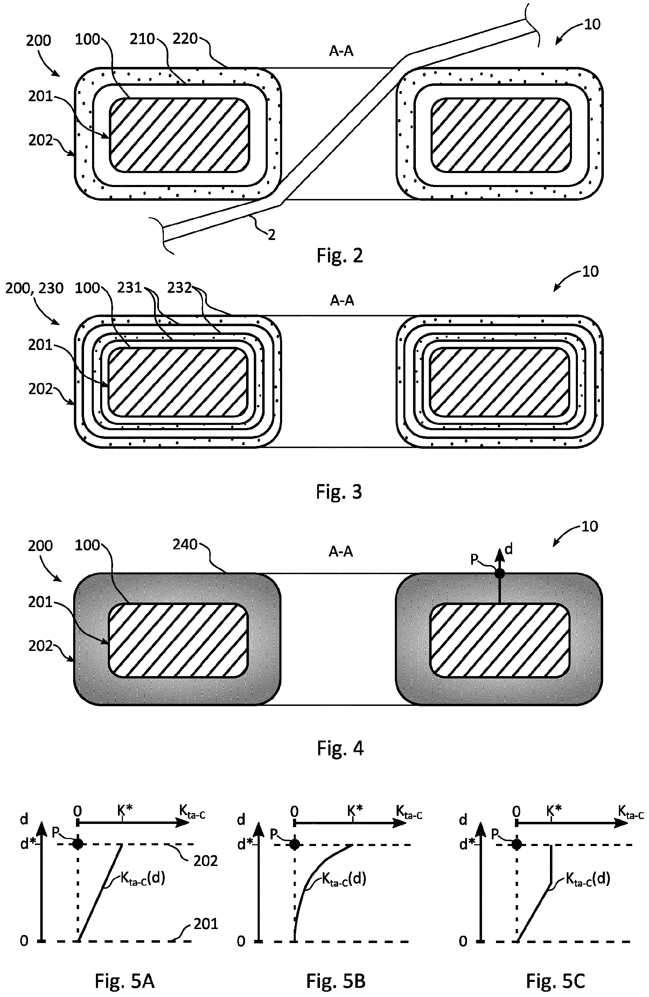

Fig. 2 zeigt ein erstes Ausführungsbeispiel einer Beschichtung 200 des erfindungsgemäßen Textilwerkzeugs am Beispiel der Lochnadel 1b aus Fig. 1B im dort gezeigten Schnitt A-A im Arbeitsabschnitt 10.

Exemplarisch ist in Fig. 2 ein Textilfaden 2 angedeutet, auf den die Lochnadel 1b in ihrem Arbeitsabschnitt 10 einwirkt. In Fig. 3 und 4 ist dieser nicht dargestellt.

Im Bereich des Arbeitsabschnitts 10 ist die Beschichtung 200 auf einen Werkzeugkern 100 (schraffierte Fläche) aus einem Kernmaterial aufgebracht. Das Werkzeugkernseitige Ende der Beschichtung 200 wird nachfolgend mit 201 bezeichnet, wohingegen das Textilfaden-seitige Ende der Beschichtung 200 nachfolgend mit 202 bezeichnet wird.

Die Beschichtung 200 umfasst eine Haftvermittlungsschicht 2 aus einem Haftvermittlungsmaterial (weiße Schicht), beispielsweise aus W-DLC, und eine Verschleißschutzschicht 220 aus ta-C (gepunktete Schicht).

Die Verschleißschutzschicht 220 aus ta-C weist eine besonders harte Oberfläche auf, mit einer geringen Anfälligkeit in Bezug auf Materialabtrag, der insbesondere durch den darüber gleitenden Textilfaden 2 verursacht wird. Dies gewährleistet eine lange Lebensdauer und senkt damit Stillstandzeiten als auch Wartungskosten der Textilmaschine.

Ferner weist die Verschleißschutzschicht 220 aus ta-C einen besonders niedrigen Reibungskoeffizienten im Kontakt zum Textilfaden 2 auf (insbesondere im Vergleich zur konventionellen Hartchrom-Beschichtung), sodass ein Gleiten des Textilfadens 2 über den Arbeitsabschnitt 10 im Zuge der Verarbeitung erleichtert wird, sodass dieser gleichmäßiger und damit kontrollierter dem Arbeitsabschnitt der Textilmaschine zugeführt werden kann. Ebenso kann durch die geringere Reibung im Kontakt auch das Risiko einer Beschädigung des Textilfadens 20 reduziert werden, wodurch wiederum die Produktqualität des letztlich herzustellenden textilen Flächengebildes erhöht wird.

Die Haftvermittlungsschicht 210 aus dem Haftvermittlungsmaterial sorgt dabei für einen besseren Verbund zwischen der Beschichtung 200 und dem Werkzeugkern 100, um so ein Ablösen bzw. ein Abplatzen der Beschichtung 200 zu verhindern. So reduziert die Haftvermittlungsschicht die inneren Spannungen im Übergang zwischen Werkzeugkern 100 und Beschichtung 200, insbesondere im Vergleich zu einem Fall, bei dem die Verschleißschutzschicht 220 aus ta-C direkt auf den Werkzeugkern 100 aufgebracht wäre.

Wie der Fig. 2 zu entnehmen ist, weist die Lochnadel 1b mehrere gekrümmte Oberflächenbereiche auf, namentlich in den Übergangen der horizontalen zu den vertikalen Außenflächen. Die Übergänge sind dabei nicht als scharfe Kanten ausgestaltet, sondern sind abgerundet und kennzeichnen sich durch einen entsprechenden Krümmungsradius. Um das Risiko von Abplatzungen der Beschichtung zu reduzieren, unterschreiten diese dabei nicht das Minimum von vorzugsweise 70 $\mu$m.

Fig. 3 zeigt ein zweites Ausführungsbeispiel einer Beschichtung 200 des erfindungsgemäßen Textilwerkzeugs am Beispiel der Lochnadel 1b aus Fig. 1B im dort gezeigten Schnitt A-A im Arbeitsabschnitt 10.

Die Beschichtung 200 umfasst hier eine Mehrlagenschicht 230, die in abwechselnder Reihenfolge in Dickenrichtung Schichten 231 aus dem Haftvermittlungsmaterial (weiße Schichten) und Schichten 232 aus dem ta-C (gepunktete Schichten) aufweisen. In der Schnittstelle 201 zum Werkzeugkern 100 ist dabei eine Schicht 231 des Haftvermittlungsmaterial vorgesehen und an der Schnittstelle 202 zum Textilfaden eine Schicht 232 aus ta-C.

Durch die Mehrlagenschicht 230 können die inneren Spannungen im Gesamtverbund aus Werkzeugkern 100 und Beschichtung 200 weiter reduziert werden, um so das Risiko eines Abplatzens weiter zu reduzieren.

Fig. 4 zeigt ein drittes Ausführungsbeispiel einer Beschichtung 200 des erfindungsgemäßen Textilwerkzeugs am Beispiel der Lochnadel 1b aus Fig. 1B im dort gezeigten Schnitt A-A im Arbeitsabschnitt 10.

Die Beschichtung 200 umfasst hier eine als Gradientenschicht 240 ausgebildete Hybridschicht, die aus einer Materialmischung aus einem Haftvermittlungsmaterial und dem ta-C als Verschleißschutzmaterial ausgebildet ist.

Durch den Einsatz der Gradientenschicht 240 kann im Vergleich zur Ausführung mit getrennten Schichten, wie beispielsweise in Fig. 2, also mit den zwei Schnittstellen Werkzeugkern 100 / Haftvermittlungsschicht 210 und Haftvermittlungsschicht 210 / Verschleißschutzschicht 220, ein besonders stetiger Verlauf innerer Spannungen ohne Spannungsspitzen umgesetzt werden, wodurch sich das Risiko von Abplatzungen der Beschichtung zusätzlich reduzieren lässt.

So liegt zudem im Vergleich zum ersten Ausführungsbeispiel aus Fig. 2 lediglich eine Materialschnittstelle vor, wodurch das Risiko von Abplatzungen weiter reduziert wird.

Im gezeigten dritten Ausführungsbeispiel ist die Konzentration an ta-C am Textilfaden-seitigen Ende 202 der Gradientenschicht 240 maximal und die Konzentration des Haftvermittlungsmaterials ist am Werkzeugkern-seitigen Ende 201 der Gradientenschicht 240 maximal. Dadurch weist die Gradientenschicht 240 im Kontakt mit dem Textilfaden ihre maximale Widerstandsfähigkeit auf und zeitgleich werden die in der verbleibenden Schnittstelle zum Werkzeugkern auftretenden inneren Spannungen minimal.

Besagte Gradientenschicht 240 kann beispielsweise durch ein PVD-Verfahren auf den Werkzeugkern 100 aufgetragen werden, bei dem, wie dem Fachmann bekannt, die aufzubringenden Materialien in Materialquellen bereitgestellt werden, aus denen heraus diese in die Gasphase überführt werden. Im Falle der Gradientenschicht 240 werden dabei zumindest eine Quelle für das ta-C und eine Quelle für das Haftvermittlungsmaterial bereitgestellt Durch zeitgleiches Überführen der beiden Materialien in die Gasphase kann so eine Hybridschicht abgelagert werden. Über das Verhältnis der den Quellen zugeführten Leistungen oder anderer eine Gasmenge eines Materials bestimmender Prozessparameter kann dabei ein Verhältnis von ta-C und dem Haftvermittlungsmaterial in der Gasphase eingestellt und über die Zeit auch variiert werden.

Es sei angemerkt, dass zwischen der Gradientenschicht 240 und dem Werkzeugkern 100 noch weitere Schichten angeordnet sein können, beispielsweise eine reine Haftvermittlungsschicht entweder aus dem Haftvermittlungsmaterial der Hybridschicht oder aber aus einem weiteren Haftvermittlungsmaterial.

Fig. 5A bis 5C zeigen exemplarische Konzentrationsverläufe von ta-C in der Gradientenschicht 240 in Dickenrichtung am Punkt P aus Fig. 4.

In den dargestellten Diagrammen bezeichnet d die Koordinate in Dickenrichtung ausgehend vom Werkzeugkern-seitigen Ende 201 der Beschichtung 200 bis zum Textilfaden-seitigen Ende 202 der Beschichtung 200, wobei eine Gesamtdicke am Punkt P mit d* bezeichnet ist

Die in Dickenrichtung variierende Konzentration an ta-C in der Gradientenschicht ist mit $K_{ta-C}$ bezeichnet und als Funktion der Koordinate d angegeben. Die Konzentration am Textilfaden-seitigen Ende 202 ist dabei mit K* bezeichnet. Die angegebenen Konzentrationen können als Massen-% verstanden werden.

Fig. 5A zeigt einen linearen Verlauf, bei dem die Konzentration ausgehend von 0% linear über die Dickenkoordinate d bis zum Maximum K* bei d=d* ansteigt.

Fig. 5B zeigt einen polynomiellen Verlauf höherer Ordnung, bei dem die Konzentration ausgehend von 0% und mit einem Gradienten $\frac{\partial K}{\partial d}(d = 0) = 0$ über die Dicke d bis zum Maximum K* ansteigt

Fig. 5C zeigt einen abschnittsweise definierten Verlauf, bei dem ein anfänglich linearer Verlauf in eine konstante Konzentration K* übergeht und diese bis zum Textilfaden-seitigen Ende 202 beibehält.

Die gezeigten Konzentrationsverläufe sind dabei allesamt stetig umgesetzt, um so einen stetigen Verlauf der inneren Spannungen und damit einen verbesserten Verbund innerhalb der Beschichtung zu gewährleisten, umso beispielsweise das Risiko von Abplatzungen zu verhindern.

Der Konzentrationsverlauf soll dabei allerdings nicht auf die gezeigten Verläufe beschränkt verstanden werden.

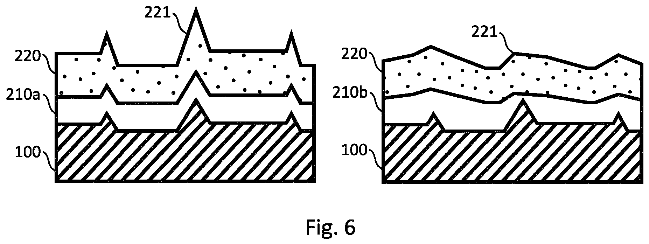

Fig. 6 zeigt eine schematische und lediglich qualitative Gegenüberstellung bei Einsatz von W-DLC als Haftvermittlungsmaterial für die Haftvermittlungsschicht.

Die Darstellung soll die glättenden Eigenschaften des W-DLC beim Einsatz als Haftvermittlungsmaterial für eine Haftvermittlungsschicht der Beschichtung verdeutlichen, auf die eine ta-C Verschleißschutzschicht aufgebracht ist, insbesondere zur Verdeutlichung der "Glättung" durch das W-DLC.

Fig. 6 zeigt links eine auf einen Werkzeugkern 100 aufgetragene Beschichtung mit einer Haftvermittlungsschicht 201a aus CrN und einer darauf aufgebrachten Verschleißschutzschicht 220 aus ta-C.

Der Einsatz von CrN führt dazu, dass sich im Wege des Aufbaus der Beschichtung Rauheiten des Werkzeugkerns 100 nahezu eins zu eins über die Haftvermittlungsschicht 201a auf die Verschleißschutzschicht 220 übertragen und dort zu den entsprechenden Rauheitsspitzen 221 führen, die sich negativ auf die Reibung zwischen Textilfaden und Textilwerkzeug auswirken und unter anderem auch zu Beschädigungen des Textilfadens führen.

Dagegen zeigt Fig. 6 rechts eine auf einen Werkzeugkern 100 aufgetragene Beschichtung mit einer Haftvermittlungsschicht 201b aus W-DLC und einer darauf aufgebrachten Verschleißschutzschicht 220 aus ta-C.

Der Einsatz von W-DLC führt dazu, dass im Wege des Aufbaus der Beschichtung Rauheiten des Werkzeugkerns 100 über die Haftvermittlungsschicht 201b hinweg geglättet werden und sich nur in abgeschwächter Form auf die Verschleißschutzschicht 220 übertragen und dort zu Rauheitsspitzen 221 führen, die im Vergleich zum Einsatz von Cr deutlich niedriger ausfallen, sodass eine an sich glattere Oberfläche der Verschleißschutzschicht 220 erreicht wird, was sich wiederum positiv auf die Reibung zwischen Textilfaden und Textilwerkzeug auswirkt und das Risiko von Beschädigungen des Textilfadens minimiert.

Vorstehend wurden Ausführungsbeispiele der vorliegenden Erfindung sowie deren Vorteile detailliert unter Bezugnahme auf die beigefügten Figuren beschrieben.

Abschließend wird erneut hervorgehoben, dass die vorliegende Erfindung in keiner Weise auf die vorstehend beschriebenen Ausführungsbeispiele und deren Ausführungsmerkmale begrenzt ist Die Erfindung umfasst weiterhin Modifikationen der genannten Ausführungsbeispiele, insbesondere diejenigen, die aus Modifikationen und/oder Kombinationen einzelner oder mehrerer Merkmale der beschriebenen Ausführungsbeispiele im Rahmen des Schutzumfanges der unabhängigen Ansprüche hervorgehen.

Liste der Bezugszeichen

| 1a | Schiebernadel |
| 1b | Lochnadel |
| 1c | Wirkplatine |
| 2 | Textilfaden |
| 10 | Arbeitsabschnitt |
| 20 | Halteabschnitt |
| 100 | Werkzeugkern |
| 200 | Beschichtung |
| 201 | Werkzeugkern-seitiges Ende der Beschichtung |
| 202 | Textilfaden-seitiges Ende der Beschichtung |
| 210, 210a, 210b | Haftvermittlungsschicht |
| 220 | Verschleißschutzschicht |
| 221 | Rauheitsspitzen |
| 230 | Mehrlagenschicht |
| 231 | Schicht aus Haftvermittlungsmaterial |
| 232 | ta-C Schicht |
| 240 | Gradientenschicht |

**Patentansprüche**

**1.** Textilwerkzeug (1a, 1b, 1c) zum Einsatz in einer Textilmaschine, das einen Arbeitsabschnitt (10) zum Einwirken auf einen Textilfaden (2) im Zuge einer Herstellung eines textilen Flächengebildes aufweist, wobei das Textilwerkzeug (1a, 1b, 1c) einen Werkzeugkern (100) aus einem Kernmaterial umfasst, auf den zumindest im Arbeitsabschnitt (10) eine Beschichtung (200) zum Verschleißschutz aufgebracht ist,
**dadurch gekennzeichnet, dass**
die Beschichtung (200) ein Haftvermittlungsmaterial und tetraedrischen amorphen Kohlenstoff, kurz ta-C, als Verschleißschutzmaterial umfasst.

**2.** Textilwerkzeug (1a, 1b, 1c) zumindest nach Anspruch 1, wobei
das Haftvermittlungsmaterial aus der Gruppe Cr, CrN, Ti, TiAlN ausgewählt ist.

**3.** Textilwerkzeug (1a, 1b, 1c) zumindest nach Anspruch 1, wobei
das Haftvermittlungsmaterial Wolfram dotiertes DLC ist, kurz W-DLC.

**4.** Textilwerkzeug (1a, 1b, 1c) zumindest nach einem der Ansprüche 1 bis 3, wobei
der Werkzeugkern (100) des Textilwerkzeugs (1a, 1b, 1c) derart ausgestaltet ist, dass ein minimaler Krümmungsradius im Arbeitsabschnitt des Textilwerkzeugs (1a, 1b, 1c) größer gleich 40 $\mu$m ist.

**5.** Textilwerkzeug (1a, 1b, 1c) zumindest nach einem der Ansprüche 1 bis 4, wobei
die Beschichtung (200) zumindest eine Haftvermittlungsschicht (210) aus dem Haftvermittlungsmaterial und einer Verschleißschutzschicht (220) aus dem ta-C umfasst, wobei die Haftvermittlungsschicht (210) zwischen dem Werkzeugkern (100) und der Verschleißschutzschicht (220) angeordnet ist.

**6.** Textilwerkzeug (1a, 1b, 1c) nach Anspruch 5, wobei
eine Dicke der Verschleißschutzschicht (220) zwischen 0,1 und 3 $\mu$m liegt, insbesondere zwischen 0,3 und 2 $\mu$m.

**7.** Textilwerkzeug (1a, 1b, 1c) zumindest nach einem der Ansprüche 5 oder 6, wobei
eine Dicke der Haftvermittlungsschicht (210) zwischen 0,01 und 2 $\mu$m liegt, insbesondere zwischen 0,2 und 0,8 $\mu$m.

**8.** Textilwerkzeug (1a, 1b, 1c) zumindest nach Anspruch 5, wenn dieser auf Anspruch 3 rückbezogen ist, wobei
die Haftvermittlungsschicht (210) eine Dicke zwischen 0,1 und 10 $\mu$m und die Verschleißschutzschicht (220) eine Dicke zwischen 0,1 und 10 $\mu$m aufweist.

**9.** Textilwerkzeug (1a, 1b, 1c) nach einem der Ansprüche 1 bis 4, wobei
die Beschichtung (200) als Mehrlagenschicht (230) ausgeführt ist, die zwei oder mehr Schichten (231) aus dem Haftvermittlungsmaterial und zwei oder mehr Schichten (232) aus dem ta-C umfasst, die in einer Dickenrichtung der Mehrlagenschicht (230) jeweils abwechselnd angeordnet sind.

**10.** Textilwerkzeug (1a, 1b, 1c) zumindest nach einem der Ansprüche 1 bis 4, wobei
die Beschichtung (200) eine Hybridschicht aus einer Materialmischung zumindest aus dem Haftvermittlungsmaterial und dem ta-C umfasst.

**11.** Textilwerkzeug (1a, 1b, 1c) nach Anspruch 10, wobei
die Hybridschicht eine Gradientenschicht (240) ist, bei der eine Konzentration des ta-C in Dickenrichtung der Gradientenschicht (240) variiert.

**12.** Textilwerkzeug (1a, 1b, 1c) nach Anspruch 11, wobei
die Konzentration an ta-C an einem Textilfaden-seitigen Ende (202) der Gradientenschicht (240) maximal ist und/oder die Konzentration des Haftvermittlungsmaterials an einem Werkzeugkern-seitigen Ende (201) der Gradientenschicht (240) maximal ist

**13.** Textilwerkzeug (1a, 1b, 1c) zumindest nach einem der Ansprüche 11 oder 12, wobei
die Konzentration an ta-C ausgehend von einem Werkzeugkern-seitigen Ende (201) bis zu einem Textilfaden-seitigen Ende (202) der Gradientenschicht (240) ansteigt, insbesondere ist die Konzentration an ta-C in Dickenrichtung monoton steigend.

**14.** Textilwerkzeugverbund, umfassend:

- eine Vielzahl von Textilwerkzeugen (1a, 1b, 1c) nach einem der Ansprüche 1 bis 13; und
- ein Halteelement, an dem die Textilwerkzeuge (1a, 1b, 1c) nebeneinander befestigt sind.

**15.** Textilmaschine zur Herstellung von textilen Flächengebilden, zumindest umfassend:

- eine Vielzahl von Textilwerkzeugen (1a, 1b, 1c) nach einem der Ansprüche 1 bis 13; und
- einen Arbeitsbereich, in dem die Textilmaschine eine Vielzahl von Textilfäden mittels der Vielzahl von Textilwerkzeugen (1a, 1b, 1c) zu einem textilen Flächengebilde verarbeitet.

**Claims**

**1.** A textile tool (1a, 1b, 1c) for use in a textile machine, which has a working section (10) for acting on a textile thread (2) in the course of producing a textile fabric, wherein the textile tool (1a, 1b, 1c) comprises a tool core (100) made of a core material, to which a coating (200) for wear protection is applied at least in the working section (10),
**characterized in that**
the coating (200) comprises an adhesion-promoting material and tetrahedral amorphous carbon, ta-C for short, as wear protection material.

**2.** A textile tool (1a, 1b, 1c) at least according to Claim 1, wherein
the adhesion-promoting material is selected from the group Cr, CrN, Ti, TiAlN.

**3.** A textile tool (1a, 1b, 1c) at least according to Claim 1, wherein
the adhesion-promoting material is tungsten-doped DLC, W-DLC for short.

**4.** A textile tool (1a, 1b, 1c) according to at least one of Claims 1 to 3, wherein
the tool core (100) of the textile tool (1a, 1b, 1c) is configured in such a way that a minimum radius of curvature in the working section of the textile tool (1a, 1b, 1c) is greater than or equal to 40 $\mu$m.

**5.** A textile tool (1a, 1b, 1c) according to at least one of Claims 1 to 4, wherein
the coating (200) comprises at least one adhesion-promoting layer (210) made of the adhesion-promoting material and a wear protection layer (220) made of the ta-C, wherein the adhesion-promoting layer (210) is arranged between the tool core (100) and the wear protection layer (220).

**6.** A textile tool (1a, 1b, 1c) according to Claim 5, wherein
a thickness of the wear protection layer (220) is between 0.1 and 3 $\mu$m, in particular between 0.3 and 2 $\mu$m.

**7.** A textile tool (1a, 1b, 1c) according to at least either of Claims 5 and 6, wherein
a thickness of the adhesion-promoting layer (210) is between 0.01 and 2 $\mu$m, in particular between 0.2 and 0.8 $\mu$m.

**8.** A textile tool (1a, 1b, 1c) at least according to Claim 5, if this refers back to Claim 3, wherein
the adhesion-promoting layer (210) has a thickness of between 0.1 and 10 $\mu$m and the wear protection layer (220) has a thickness of between 0.1 and 10 $\mu$m.

**9.** A textile tool (1a, 1b, 1c) according to one of Claims 1 to 4, wherein
the coating (200) is embodied as a multilayer layer (230) which comprises two or more layers (231) made of the adhesion-promoting material and two or more layers (232) made of the ta-C, which are arranged alternately in each case in a thickness direction of the multilayer layer (230).

10. A textile tool (1a, 1b, 1c) according to at least one of Claims 1 to 4, wherein
the coating (200) comprises a hybrid layer made of a material mixture at least of the adhesion-promoting material and the ta-C.

11. A textile tool (1a, 1b, 1c) according to Claim 10, wherein
the hybrid layer is a gradient layer (240) in which a concentration of the ta-C varies in the thickness direction of the gradient layer (240).

12. A textile tool (1a, 1b, 1c) according to Claim 11, wherein
the concentration of ta-C is at a maximum at a textile thread-side end (202) of the gradient layer (240) and/or the concentration of the adhesion-promoting material is at a maximum at a tool core-side end (201) of the gradient layer (240).

13. A textile tool (1a, 1b, 1c) according to at least either of Claims 11 and 12, wherein
the concentration of ta-C increases from a tool core-side end (201) to a textile thread-side end (202) of the gradient layer (240), in particular the concentration of ta-C increases monotonically in the thickness direction.

14. A textile tool assembly, comprising:

- a plurality of textile tools (1a, 1b, 1c) according to one of Claims 1 to 13; and
- a holding element to which the textile tools (1a, 1b, 1c) are fastened next to one another.

15. Textile machine for producing textile fabrics, at least comprising:

- a multiplicity of textile tools (1a, 1b, 1c) according to one of Claims 1 to 13; and
- a working region in which the textile machine processes a plurality of textile threads by means of the plurality of textile tools (1a, 1b, 1c) to form a textile fabric.

## Revendications

1. Outil textile (1a, 1b, 1c) destiné à être utilisé dans une machine textile, qui présente une section de travail (10) pour agir sur un fil textile (2) au cours d'une fabrication d'une structure textile plane, l'outil textile (1a, 1b, 1c) comprenant un noyau d'outil (100) en un matériau de noyau, sur lequel est appliqué au moins dans la section de travail (10) un revêtement (200) pour la protection contre l'usure,
**caractérisé en ce que**
le revêtement (200) comprend un matériau promoteur d'adhérence et du carbone amorphe tétraédrique, en abrégé ta-C, en tant que matériau de protection contre l'usure.

2. Outil textile (1a, 1b, 1c) au moins selon la revendication 1,
le matériau promoteur d'adhérence étant choisi dans le groupe constitué par Cr, CrN, Ti, TiAlN.

3. Outil textile (1a, 1b, 1c) au moins selon la revendication 1,
le matériau promoteur d'adhérence étant du DLC dopé au tungstène, en abrégé W-DLC.

4. Outil textile (1a, 1b, 1c) au moins selon l'une quelconque des revendications 1 à 3,
le noyau d'outil (100) de l'outil textile (1a, 1b, 1c) étant configuré de telle sorte qu'un rayon de courbure minimal dans la section de travail de l'outil textile (1a, 1b, 1c) soit supérieur ou égal à 40 $\mu$m.

5. Outil textile (1a, 1b, 1c) au moins selon l'une quelconque des revendications 1 à 4,
le revêtement (200) comprenant au moins une couche promoteur d'adhérence (210) en le matériau promoteur d'adhérence et une couche de protection contre l'usure (220) en le taC, la couche promoteur d'adhérence (210) étant disposée entre le noyau d'outil (100) et la couche de protection contre l'usure (220).

6. Outil textile (1a, 1b, 1c) selon la revendication 5,
une épaisseur de la couche de protection contre l'usure (220) étant comprise entre 0,1 et 3 $\mu$m, en particulier entre 0,3 et 2 $\mu$m.

7. Outil textile (1a, 1b, 1c) au moins selon l'une quelconque des revendications 5 ou 6,
une épaisseur de la couche promoteur d'adhérence (210) étant comprise entre 0,01 et 2 $\mu$m, en particulier entre 0,2 et 0,8 $\mu$m.

8. Outil textile (1a, 1b, 1c) au moins selon la revendication 5, lorsqu'elle dépend de la revendication 3,
la couche promoteur d'adhérence (210) présentant une épaisseur comprise entre 0,1 et 10 $\mu$m et la couche de protection contre l'usure (220) présentant une épaisseur comprise entre 0,1 et 10 $\mu$m.

9. Outil textile (1a, 1b, 1c) selon l'une quelconque des revendications 1 à 4,
le revêtement (200) étant réalisé sous forme de couche multicouche (230), qui comprend deux couches ou plus (231) en le matériau promoteur d'adhérence et deux couches ou plus (232) en le ta-C, qui sont disposées à chaque fois en alternance dans une direction d'épaisseur de la couche multicouche (230).

10. Outil textile (1a, 1b, 1c) au moins selon l'une quelconque des revendications 1 à 4,
le revêtement (200) comprenant une couche hybride en un mélange de matériaux au moins en le matériau promoteur d'adhérence et le ta-C.

11. Outil textile (1a, 1b, 1c) selon la revendication 10, la couche hybride étant une couche à gradient (240), dans laquelle une concentration du ta-C varie dans la direction d'épaisseur de la couche à gradient (240).

12. Outil textile (1a, 1b, 1c) selon la revendication 11, la concentration en ta-C étant maximale à une extrémité côté fil textile (202) de la couche à gradient (240) et/ou la concentration en matériau promoteur d'adhérence étant maximale à une extrémité côté noyau d'outil (201) de la couche à gradient (240).

13. Outil textile (1a, 1b, 1c) au moins selon l'une quelconque des revendications 11 ou 12,
la concentration en ta-C augmentant à partir d'une extrémité côté noyau d'outil (201) jusqu'à une extrémité côté fil textile (202) de la couche à gradient (240), en particulier la concentration en ta-C augmentant de manière monotone dans la direction d'épaisseur.

14. Ensemble d'outils textiles, comprenant :

   - une pluralité d'outils textiles (1a, 1b, 1c) selon l'une quelconque des revendications 1 à 13 ; et
   - un élément de retenue, sur lequel les outils textiles (1a, 1b, 1c) sont fixés les uns à côté des autres.

15. Machine textile pour la fabrication de structures textiles planes, comprenant au moins :

   - une pluralité d'outils textiles (1a, 1b, 1c) selon l'une quelconque des revendications 1 à 13 ; et
   - une zone de travail, dans laquelle la machine textile traite une pluralité de fils textiles au moyen de la pluralité d'outils textiles (1a, 1b, 1c) en une structure textile plane.

Fig. 1A

Fig. 1B

Fig. 1C

Fig. 2

Fig. 3

Fig. 4

Fig. 5A

Fig. 5B

Fig. 5C

Fig. 6

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19635736 A1
- JP 2014221962 A
- DE 102018119910 A1
- DE 102010002687 A1
- DE 102010052971 A1
- EP 3483319 A1